# EUROPEAN PATENT APPLICATION

(11) **EP 3 767 824 A1**
(43) Date of publication of application: **20.01.2021**
(21) Application number: 18911196.6
(22) Date of filing: 22.03.2018
(51) Int. Cl.: H02S 30/00

(54) **SIDE SURFACE LIGHT-CONCENTRATING SOLAR DEVICE**

(71) Applicant: Bolymedia Holdings Co. Ltd., Santa Clara, California 95051 (US)
(72) Inventor: HU, Xiaoping, Shenzhen, Guangdong 518109 (CN)
(74) Representative: Manitz Finsterwald Patent- und Rechtsanwaltspartnerschaft mbB
(86) International application number: PCT/CN2018/079964
(87) International publication number: WO 2019/178798

(57) **Abstract**

A side concentrating solar apparatus, comprising a light receiving device (110) and two reflector panels, wherein a first reflector panel (120) is disposed at a side of the light receiving device, a second reflector panel (130) is disposed at an upper edge of the first reflector panel, and an included angle (α) of a light reflecting surface of the second reflector panel and a light reflecting surface of the first reflector panel is an obtuse angle, such that light rays that reach each reflector panel are at least partially guided to the light receiving device. By means of the reflector panels that are disposed at side surfaces, the light concentrating capabilities of the device may be enhanced at a lower cost such that the device is capable of easily being designed as an upright structure, which is beneficial in reducing the area occupied by the device.

## Description

### Technical Field

The present disclosure relates to clean energy, in particular to side concentrating solar apparatus.

### Background

Solar systems have been growing in popularity with increasing demand for clean energy due to worsening global warming problem. The solar energy systems available can be divided into two types: light-concentrating and non-concentrating.

A non-concentrating solar system mainly relies on light energy utilization devices, such as photovoltaic panels, to collect sunlight directly. It requires a large number of photovoltaic panels, which occupy a large area of land, resulting in high system costs and low land use efficiency.

A light-concentrating solar system generally converge sunlight on light energy utilization devices located below (or at rear end) through lenses located above (or at front end). It may be good at light energy collection. However, the light-concentrating solar system usually needs to be used in conjunction with a sun-tracking system to achieve a desired effect, which is not only costly, but also cannot effectively reduce the land occupation.

Therefore, it is necessary to study a concentrating solar system that is cost-effective and can help reduce the demand for land.

### Summary of the Invention

A side concentrating solar apparatus provided according to the present disclosure may include at least one light receiving device and two reflecting panels, wherein the light receiving device, which may be a light energy utilization device, or a combination of a light energy utilization device and a light concentrating device, defines a first incident range for receiving sunlight, and the light within the first incident range is capable of reaching a first surface of the light energy utilization device. The first reflecting panel is arranged on one side of the light receiving device, the second reflecting panel is arranged at the upper edge of the first reflecting panel, and an included angle between the reflective surface of the second reflecting panel and the reflective surface of the first reflecting panel is an obtuse angle so that the light reaching the first and second reflecting panels can be at least partially guided to the first incident range.

Preferably, the light receiving device can be in a form of a combination of a light energy utilization device and a conical light-condensing tube or a light-condensing groove.

With the side concentrating solar apparatus according to the present disclosure, it is capable of collecting light energy from a larger area simply by the reflecting panel provided on a side thereof; consequently, the light energy collection of the apparatus can be effectively improved with only a small increase in cost. In addition, such side concentrating allows the apparatus to be easily designed as an upright structure, that is, the size in the height direction is larger than the size in the width direction (and the size in the length direction can be extended as needed), thereby helping to reduce the area occupied by the apparatus. Moreover, it is also easy to be integrated with such as farmland and roads, for example, it is set up at the edge of the field or beside the road, thereby further improving the land utilization rate.

Specific examples according to the present disclosure are described in detail below with reference to the accompanying drawings. As used herein, the serial numbers or sequence numbers used herein, such as "first", "second", etc., are merely illustrative without any restrictive meanings. Terms that indicate a position, such as "upper", "lower", "front", "rear", "side", "top", "bottom", "laterally", "vertical" and the like, only refer to relative positional relationships, having no absolute meanings.

### Brief Description of the Drawings

FIG. 1 is a schematic diagram of a side concentrating solar apparatus according to Embodiment 1;
FIG. 2 is a schematic diagram of a concentrating light energy utilization device according to the present disclosure;
FIG. 3 is a schematic diagram of a side concentrating solar apparatus according to Embodiment 2;
FIG. 4 is a schematic diagram of a double-sided concentrating light energy utilization device according to the present disclosure;
FIG. 5 is a schematic diagram of a side concentrating solar apparatus according to Embodiment 3;
FIG. 6 is a schematic diagram of a side concentrating solar apparatus according to Embodiment 4; and
FIG. 7 is a schematic diagram of a side concentrating solar apparatus according to Embodiment 5.

### Detailed Description

### Embodiment 1

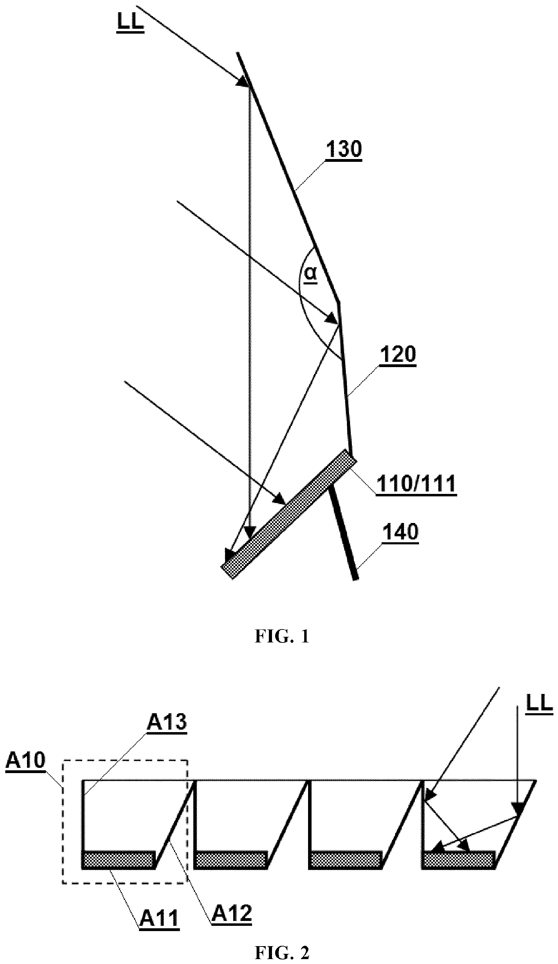

Referring to FIG. 1, one longitudinal section of a side concentrating solar apparatus according to an embodiment of the present disclosure is schematically shown. The solar system includes a light receiving device 110, a first reflecting panel 120 and a second reflecting panel 130. LL shown in the figure and the following figures represents sunlight whose light path is indicated by arrows.

The light receiving device 110 uses a photovoltaic panel 111. The photovoltaic panel herein generally refers to any device that directly converts light energy into electrical energy, including various semiconductor photovoltaic panels, photovoltaic films, quantum dot photoelectric conversion devices, etc.

The first reflecting panel 120 is arranged on one side of the photovoltaic panel 111, and the angle between the reflective surface of the first reflecting panel and the photovoltaic panel can be set as required, and in this embodiment, it is set to be an obtuse angle. The second reflecting panel 130 is arranged at the upper edge of the first reflecting panel, and the included angle α between the reflective surface of the second reflecting panel and the reflective surface of the first reflecting panel is an obtuse angle, so that the light reaching the first and second reflecting panels is at least partially guided to the surface (front side) of the photovoltaic panel. By choosing the angle of each reflective surface, as much sunlight as possible can reach the photovoltaic panel.

In this embodiment, the light receiving device only includes photovoltaic panels. In other embodiments, the light receiving device may also be another type of light energy utilization device, such as a photothermal utilization device or a combination of a photovoltaic panel and a photothermal utilization device. The light receiving device can also be a combination of a light energy utilization device and a light concentrating device, which can be called a "concentrating light energy utilization device". The light concentrating device can be selected from, for example, a conical light-condensing tube and a light-condensing groove. In this respect, the conical light-condensing tube which adopts a reflective surface as its inner wall has a top opening larger than the one at the bottom; and a corresponding light energy utilization device is arranged at the bottom of the conical light-condensing tube. The light-condensing groove provided with reflective surfaces on both side walls is strip-shaped, having a width at the top greater than that at the bottom; and a corresponding light energy utilization device is arranged at the bottom of the light-condensing groove. These light concentrating devices formed with reflective surfaces can increase the concentration ratio of the apparatus at a lower cost.

Generally, the light receiving device defines a first incident range for receiving sunlight; and light in the first incident range can reach the first surface (which may be for example referred to as a "front surface") of the light energy utilization device. When the light receiving device only includes the light energy utilization device, the first incident range is the range defined by the front surface of the light energy utilization device. When the light receiving device is a concentrating light energy utilization device, the first incident range is usually defined by the light entrance (e.g. the top opening of the conical light-condensing tube or the light-condensing groove) of the light concentrating device. As a preferred embodiment, the concentrating light energy utilization device may include a plurality of units which are closely arranged to form a row structure, a column structure or an array structure. Each unit includes a light energy utilization device and a conical light-condensing tube or a light-condensing groove. Such structure miniaturizes a single unit, and it is beneficial to maintain the optical parameters (e.g. the angle of the reflective surface of the light concentrating device) and reduce the height of the light receiving device.

FIG. 2 shows a longitudinal section of a preferred concentrating light energy utilization device. The device adopts a structure in which multiple units are integrated. Each unit A10 includes a strip-shaped light-condensing groove and a photovoltaic panel A11 arranged at the bottom of the groove, and the groove walls A12, A13 on both sides are reflective surfaces. Generally, the angles between the reflective surfaces on both sides and the bottom surface can be the same or different, and the former is suitable for the case where the light path before the light concentrating device has a symmetrical structure. For a single-sided light-concentrating structure shown in FIG. 1, it is preferred that the angles between the reflective surfaces on both sides and the bottom surface are different, for example, one is a right angle and the other is an obtuse angle.

As a preferred embodiment, this embodiment may further include a supporting mechanism 140, on which the solar apparatus is integrally installed, so as to adjust the inclination angle or orientation of the light receiving device or the entire solar apparatus. In the embodiment, since the lower edge of the first reflecting panel is fixedly connected to the side of the photovoltaic panel, it is equivalent to the light receiving device and each reflective panel being formed as a whole. In other embodiments, the light receiving device can also be independently mounted on the supporting mechanism without being fixed to each reflective panel, so that the inclination angle or orientation of the light receiving device can be individually adjusted. Further preferably, the supporting mechanism may adopt a sun-tracking bracket for adjusting a desired inclination angle or orientation according to the needs of sun tracking.

This embodiment provides a simple upright side concentrating solar apparatus. The first reflecting panel is erected on one side of the light receiving device, and the second reflecting panel obliquely covers the light receiving device. The entire device has advantages of low cost and saving occupied area.

### Embodiment 2

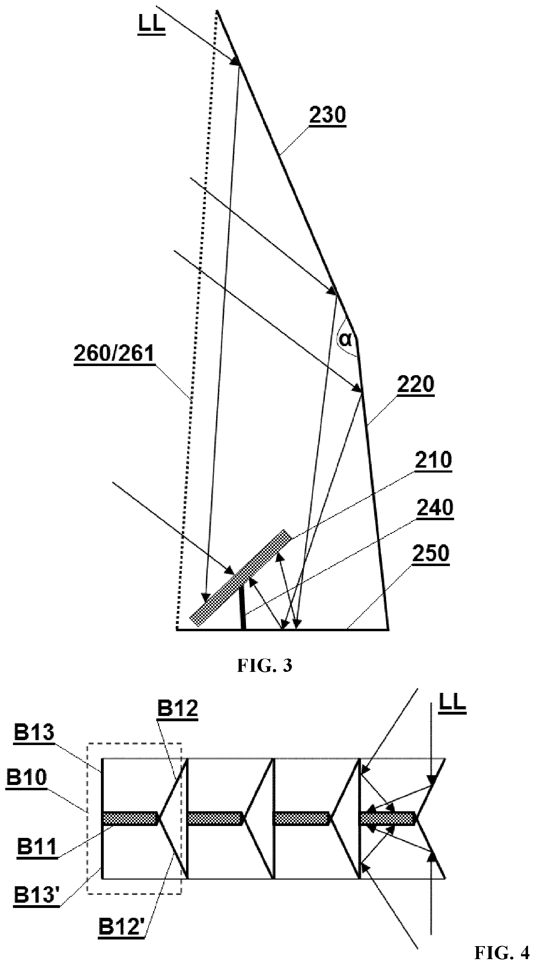

FIG. 3 schematically shows a side concentrating solar apparatus according to another embodiment of the present disclosure. Referring to FIG. 3, the apparatus includes a light receiving device 210, a first reflecting panel 220, a second reflecting panel 230 and a supporting mechanism 240.

The light receiving device 210 in this embodiment, which can receive and utilize sunlight from both sides, is a double-sided light receiving device. It includes double-sided light energy utilization devices, for example, two photovoltaic panels arranged back to back or a double-sided photovoltaic panel. Compared with Embodiment 1, the light receiving device in this embodiment may further define a second incident range for receiving sunlight; and light in the second incident range can reach the second surface (which can be for example referred to as "rear surface") of the light energy utilization device. When the double-sided light receiving device also includes light concentrating devices, they can be mirrored and symmetrically arranged on both sides of the double-sided light energy utilization device, which can be referred to as a "double-sided concentrating light energy utilization device".

Referring to FIG. 4, a longitudinal section of a preferred double-sided concentrating light energy utilization device is schematically shown. The device adopts a structure that integrates a plurality of units. Each unit B10 includes two strip-shaped light-condensing grooves arranged in mirror symmetry and a double-sided photovoltaic panel B11 arranged at the bottom of the groove. The groove walls B12, B12' and B13, B13' arranged in mirror symmetry are reflective surfaces. Since an upright structure with single-sided concentrating light is adopted in this embodiment, asymmetrical groove walls are used, in which the included angles between B12, B12' and the bottom surface are obtuse angles, and the included angles between B13, B13' and the bottom surface are right angles. In other embodiments, for example, two sets of conical light-condensing tubes with mirror symmetry can also be used as the light concentrating device.

The positional relationship between the first reflecting panel 220 and the second reflecting panel 230 in this embodiment is similar to that in Embodiment 1, but there is a gap between the light receiving device 210 and the reflective surface of the first reflecting panel. Compared with Embodiment 1, this embodiment further includes a third reflecting panel 250 which is arranged at the lower edge of the first reflecting panel so that the light reaching the first reflecting panel or the second reflecting panel is at least partially reflected by the third reflecting panel and guided to the second incident range, making both sides of the light receiving device can receive sunlight. This can not only increase the concentration ratio of the apparatus, but also improve the incident angle of some light (such as the light irradiated to the rear surface), thereby improving the efficiency of light energy utilization.

The light receiving device 210 is mounted on the third reflecting panel 250 by the supporting mechanism 240, and the inclination angle or orientation can be adjusted independently.

As a preferred embodiment, this embodiment may further include a cover plate 260 for forming the solar apparatus into a closed cavity, and each reflective surface and light receiving device are located in the cavity to avoid dust pollution. Generally, at least part of the cover plate is transparent and arranged on the light path where sunlight is incident on the light energy utilization device. All of the cover plate definitely can also be transparent. In this embodiment, the front cover plate 261 of the solar apparatus is transparent, and both side cover plates may be transparent or opaque. Further preferably, the transparent cover plate may be at least partially formed by a Fresnel lens. For example, the upper part of the front cover plate 261 (that is, the part close to the second reflecting panel 230) may be a Fresnel lens to help deflect light downward, thereby increasing the angle α between the first and second reflecting panels to improve the concentration ratio of the system. The Fresnel lens used can be selected from the following types: one having a single-sided tooth surface, one having double-sided tooth surfaces, one having a circumferentially symmetric tooth surface pattern, and one having a linear tooth surface pattern.

Compared with the open structure of Embodiment 1, the closed structure adopted in this embodiment is easier to clean dust, and the double-sided light-receiving structure can have higher light energy utilization efficiency.

### Embodiment 3

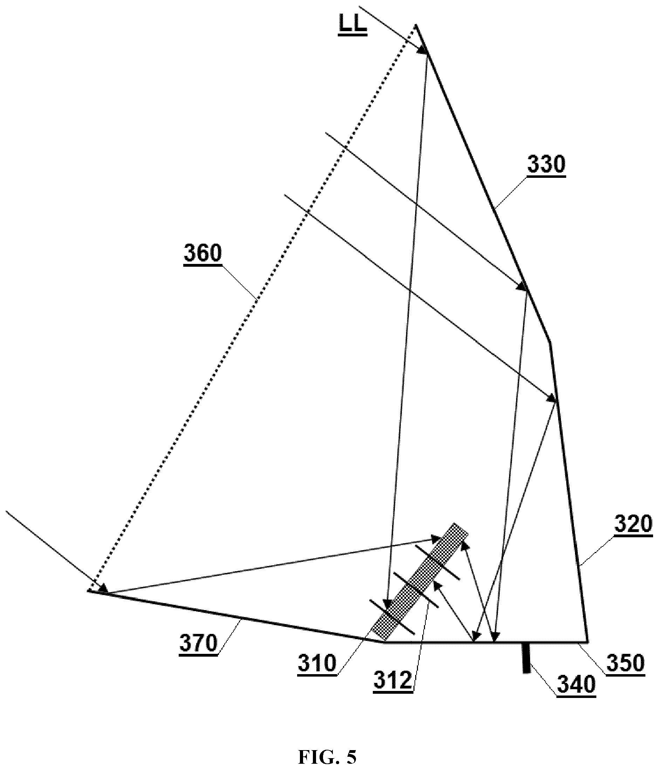

FIG. 5 schematically shows a side concentrating solar apparatus according to still another embodiment of the present disclosure. Referring to FIG. 5, the apparatus includes a light receiving device 310, a first reflecting panel 320, a second reflecting panel 330, a third reflecting panel 350, a supporting mechanism 340 and a cover plate 360.

The positional relationship of the light receiving device and the first, second, and third reflecting panels in this embodiment is similar to that in Embodiment 2, and the transparent cover plate 360 seals the entire solar apparatus into a closed cavity. The difference from Embodiment 2 includes that the solar apparatus of this embodiment is integrally installed on the supporting mechanism 340.

In addition, compared with Embodiment 2, this embodiment further includes a fourth reflecting panel 370 arranged on the other side of the light receiving device 310, wherein the other side is different from the side at which the first reflecting panel 320 is located. Moreover, the inclination angle of the reflective surface of the fourth reflecting panel relative to the light receiving device makes the light reaching the fourth reflecting panel at least partially guided to the first incident range.

Both Embodiments 1 and 2 adopt a single-sided light-concentrating structure. However, in this embodiment, a fourth reflecting panel is arranged on the other side of the light energy utilization device, so a double-sided light-concentrating structure is formed, which can further increase the concentration ratio of the system.

Due to the increase in the concentration ratio, a higher temperature may be generated when the light energy utilization device in the light receiving device adopts a photovoltaic panel. Therefore, as a preferred embodiment, this embodiment further includes at least one cooling fin 312. Each cooling fin is thermally connected to the photovoltaic panel and is arranged vertically relative to the photovoltaic panel, so that each cooling fin is erected on at least one surface of the photovoltaic panel (including crossing the photovoltaic panel and forming a criss-cross construction with its front and rear surfaces), thereby solving the heat dissipation of the photovoltaic panel. In order to avoid affecting the use of sunlight, the front and rear surfaces of the cooling fin are both mirror surfaces; for example, using a metal cooling fin coated with mirror reflection films.

### Embodiment 4

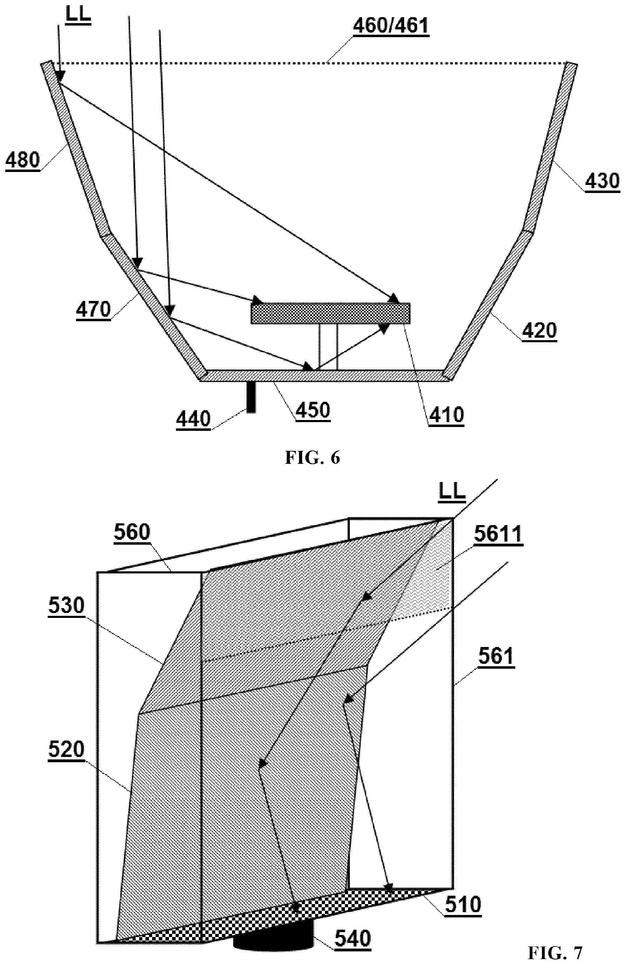

FIG. 6 schematically shows a side concentrating solar apparatus according to yet still another embodiment of the present disclosure. Referring to FIG. 6, the apparatus includes a light receiving device 410, a first reflecting panel 420, a second reflecting panel 430, a third reflecting panel 450, a fourth reflecting panel 470, a supporting mechanism 440 and a cover plate 460.

The positional relationship of the light receiving device and the first, second, third and fourth reflecting panels in this embodiment is similar to that in Embodiment 3, wherein the solar apparatus is integrally installed on the supporting mechanism 440. The difference therebetween is that double-sided symmetrical reflective structure is adopted in this embodiment. Specifically, the light receiving device 410 is fixed on the third reflecting panel 450 substantially horizontally, and this embodiment further includes a fifth reflecting panel 480 arranged at the upper edge of the fourth reflecting panel. The angle between the reflective surface of the fifth reflecting panel and the reflective surface of the fourth reflecting panel is an obtuse angle, so that the light reaching the fifth reflecting panel is at least partially reflected by the fourth reflecting panel and guided to the first incident range or second incident range (that is, the front or rear surface of the light receiving device).

The transparent cover plate 460 seals the entire solar apparatus into a closed cavity. Preferably, the cover plate 460 includes a transparent top cover 461 formed of a Fresnel lens to increase the light concentration ratio.

In other embodiments, at least one reflecting panel may be further provided on each side of the light receiving device, so that the solar apparatus is formed into a bowl shape as a whole. The bowl-shaped solar apparatus can produce a high concentration ratio. In this respect, the light energy utilization device in the light receiving device can be a photothermal utilization device, especially a photothermal utilization device having a thermal energy storage.

The side concentrating solar apparatus in Examples 1-3 are all asymmetric and upright, which are more suitable for installation in regions at mid and high latitudes. The solar apparatus of this embodiment adopts a symmetrical double-sided concentrating structure, which is suitable for installation near the equator and get a higher cost performance.

### Embodiment 5

FIG. 7 schematically shows a side concentrating solar apparatus according to still yet another embodiment of the present disclosure. Referring to FIG. 7, the apparatus includes a photovoltaic panel 510, a first reflecting panel 520, a second reflecting panel 530, a supporting mechanism 540 and a cover plate 560.

The photovoltaic panel 510 is arranged substantially horizontally, the first reflecting panel 520 is arranged on one side of the photovoltaic panel 510 at an acute angle, and the second reflecting panel is extended at an obtuse angle from the upper edge of the first reflecting panel. The cover plate 560 seals the entire solar apparatus into a substantially rectangular cavity. The front cover 561 of the cover plate is a transparent cover, and the top 5611 of the front cover is a Fresnel lens. The supporting mechanism 540 is a sun-tracking bracket capable of rotating in the direction of the sun.

The solar apparatus of this embodiment can be used to make a solar brick or a solar wall.

The principle and implementation manners of the present disclosure has been described above with reference to specific embodiments, which are merely provided for the purpose of understanding the present disclosure and should not be construed as limiting the present disclosure. It will be possible for those skilled in the art to make variations based on the idea of the present disclosure.

## Claims

1. A side concentrating solar apparatus, comprising:
a light receiving device, the light receiving device is a light energy utilization device or a combination of a light energy utilization device and a light concentrating device, the light receiving device defining a first incident range for receiving sunlight, and the light within the first incident range being capable of reaching a first surface of the light energy utilization device; and
a first reflecting panel and a second reflecting panel, the first reflecting panel being arranged at one side of the light receiving device, the second reflecting panel being arranged at the upper edge of the first reflecting panel and an included angle between the reflective surface of the second reflecting panel and the reflective surface of the first reflecting panel being an obtuse angle so that the light reaching the first reflecting panel and the second reflecting panel is at least partially guided to the first incident range.

2. The solar apparatus according to claim 1,
wherein the light concentrating device is selected from a conical light-condensing tube and a light-condensing groove,
the conical light-condensing tube adopting a reflective surface as the inner wall has a top opening larger than the one at the bottom,
The light-condensing groove shaped as a strip is provided with reflective surfaces on both side walls and has a width at the top greater than that at the bottom; and a corresponding light energy utilization device is arranged at the bottom of the light-condensing groove.

3. The solar apparatus according to claim 2,
wherein the light receiving device comprises a plurality of units which are closely arranged to form a row structure, a column structure or an array structure, each unit includes a light energy utilization device and a conical light-condensing tube or a light-condensing groove.

4. The solar apparatus according to claim 2 or 3,
the included angles between the reflective surfaces of the groove walls at both sides of the light-condensing groove and the bottom surface are identical, or
the included angles between the reflective surfaces of the groove walls at both sides of the light-condensing groove and the bottom surface are different, of which one is a right angle and the other is an obtuse angle.

5. The solar apparatus according to any one of claims 1-4,
further comprising at least one cooling fin whose front and rear surface are both mirror surfaces;
wherein the light energy utilization device is a photovoltaic panel, the at least one cooling fin is thermally connected to the photovoltaic panel and is arranged vertically relative to the photovoltaic panel so that the at least one cooling fin is erected on at least one surface of the photovoltaic panel.

6. The solar apparatus according to any one of claims 1-5,
wherein the first reflecting panel is erected at one side of the light receiving device, and the second reflecting panel obliquely covers the light receiving device.

7. The solar apparatus according to any one of claims 1-6,
further comprising a third reflecting panel,
wherein the light receiving device further defines a second incident range for receiving sunlight, the light within the second incident range is capable of reaching a second surface of the light energy utilization device which locates at the rear surface of the first surface; and
wherein there is a gap between the light receiving device and the reflective surface of the first reflecting panel, the third reflecting panel is arranged at the lower edge of the first reflecting panel so that the light reaching the first reflecting panel or the second reflecting panel is at least partially reflected by the third reflecting panel and guided to the second incident range.

8. The solar apparatus according to claim 7,
wherein the light receiving device is a combination of a double-sided light energy utilization device and light concentrating devices with mirror symmetry, the light concentrating device with mirror symmetry include two sets of conical light-condensing tubes or two sets of light-condensing grooves, which are arranged at both sides of the double-sided light energy utilization device in a mirror symmetrical manner.

9. The solar apparatus according to any one of claims 1-8,
further comprising a fourth reflecting panel arrange at the other side of the light receiving device, wherein said other side is different from the side at which the first reflecting panel located, and wherein the inclination angle of the reflective surface of the fourth reflecting panel relative to the light receiving device makes the light reaching the fourth reflecting panel at least partially guided to the first incident range.

10. The solar apparatus according to claim 9,
further comprising a fifth reflecting panel arranged at the upper edge of the fourth reflecting panel, wherein an included angle between reflective surface of the fifth reflecting panel and the reflective surface of the fourth reflecting panel is an obtuse angle so that the light reaching the fifth reflecting panel is at least partially reflected by the fourth reflecting panel and guided to the first incident range.

11. The solar apparatus according to claim 9 or 10,
wherein at least one reflecting panel is further provided on each side of the light receiving device, so that the solar apparatus is formed into a bowl shape as a whole.

12. The solar apparatus according to any one of claims 1-11,
further comprising a cover plate configured for forming the solar apparatus into a closed cavity, wherein each reflective surface and the light receiving device are located in the cavity, and
wherein at least part of the cover plate is transparent, and the transparent cover plate is arranged on the light path where sunlight is incident on the light energy utilization device.

13. The solar apparatus according to claim 12,
wherein the transparent cover plate is at least partially formed by a Fresnel lens.

14. The solar apparatus according to any one of claims 1-13,
further comprising a supporting mechanism configured for adjusting the inclination angle or orientation of the light receiving device or the integral solar apparatus, wherein the light receiving device or the integral solar apparatus is installed on the supporting mechanism.

15. The solar apparatus according to claim 14,
wherein the supporting mechanism is a sun-tracking bracket configured for adjusting the inclination angle or orientation according to the needs of sun tracking.
